# EUROPÄISCHE PATENTANMELDUNG

(11) **EP 2 918 699 A1**
(43) Veröffentlichungstag der Anmeldung: **16.09.2015**
(21) Anmeldenummer: 14159917.5
(22) Anmeldetag: 14.03.2014
(51) Int. Cl.: C23C 14/00, C23C 14/08, C23C 14/35, H01L 21/02, H01J 37/34

(54) **Verfahren zur Herstellung von Metalloxid-Halbleiterschichten und Verwendung von solchen Metalloxid-Halbleiterschichten in elektronischen Bauteilen**

(71) Anmelder: Justus-Liebig-Universität Gießen, 35390 Gießen (DE)
(72) Erfinder: Meyer, Bruno, Prof., 35440 Großen-Linden (DE); Hering, Karl Philipp, 35510 Butzbach (DE)
(74) Vertreter: Stumpf, Peter

(57) **Zusammenfassung**

Die Erfindung bezieht sich auf ein Verfahren zur Herstellung von Metalloxidschichten durch Kathodenzerstäubung unter Verwendung von Argon als Arbeitsgas und Sauerstoff (O₂) als erstem Reaktivgas, dadurch gekennzeichnet, dass mindestens ein weiteres Reaktivgas mit reduzierenden Eigenschaften gegenüber dem ersten Reaktivgas während des Sputterprozesses zugegeben wird. Ein bevorzugtes zweites Reaktivgas ist Wasserstoff (H₂).

## Beschreibung

### Technisches Gebiet der Erfindung

Die Erfindung bezieht sich auf ein Verfahren zur Herstellung von Metalloxid-Halbleiterschichten, auf diese Schichten selbst sowie deren Anwendung als aktive Schichten in Solarzellen, Metalloxid-Halbleitersensoren und anderen elektronischen Bauteilen bzw. Geräten.

### Stand der Technik

Elektrisch halbleitende Metalloxidschichten können durch reaktives Sputtern der entsprechenden Metalltargets mit Sauerstoff als Reaktivgas hergestellt werden. Es ist bekannt, dass sich die elektronischen Eigenschaften von zum Beispiel derart hergestellten Kupferoxidschichten durch eine Nachbehandlung mit zum Beispiel Wasserstoff optimieren lassen. Entsprechende Verfahren sind in der Literatur beschrieben.

S. Ishizuka et al. führen zum Beispiel an stickstoffdotierten Cu₂O-Schichten eine Nachbehandlung mit einem Wasserstoffplasma durch und beschreiben dabei, dass die Behandlung bei nicht-dotierten Cu₂O-Schichten keine nennenswerte Wirkung hat (J. cryst. Growth 237-239 (2002) 616-620).

K. Akimoto et al. beschreiben ebenfalls eine Nachbehandlung mit Wasserstoff, sowie alternativ mit einer Kaliumcyanidlösung. Auch hier wird berichtet, dass sich nur stickstoffdotierte Kupferoxidschichten effektiv nachbehandeln lassen (Appl. Surf. Sci. 216 (2003) 94-97).

N. Tabuchi und H. Matsumura beschreiben ebenfalls eine aufwendige Nachbehandlung mit Wasserstoffgas im Anschluß an den Sputterprozeß (Jpn. J. Appl. Phys. 41 (2002) 5060-5063).

In WO 2013/124134 A1 wird offenbart, dass es bei der Herstellung von Kupferoxidschichten durch Sputtern bzw. Kathodenzerstäuben möglich ist, die Zusammensetzung der Schicht durch Einstellung des Sauerstoff-Partialdruckes zu variieren: Je nach eingestelltem Sauerstoff-Partialdruck bildet sich eine Schicht, die ausschließlich oder vorwiegend aus mindestens einem der drei Oxide Cu₂O, Cu₄O₃ oder CuO besteht.

Das Verfahren des "Sputterns" bzw. "Kathodenzerstäubens" ist ein im Stand der Technik allgemein bekanntes Verfahren zur Herstellung von metallischen oder metall-oxidischen Schichten unterschiedlichster Dicke. Beide Begriffe werden synonym verwendet.

### Aufgabe

Aufgabe der Erfindung ist es, die apparativ aufwendige, zeit- und kostenzehrende Nachbehandlung von zum Beispiel Kupferoxidschichten mit reduzierend wirkender Gasatmosphäre in den Produktionsprozess der Metalloxidschicht zu integrieren. Die Erfindung beinhaltet weiterhin sowohl die erfindungsgemäß hergestellten Metalloxidschichten an sich, als auch ihre Verwendung als aktiver Schicht und/oder als Teil von aktiven Schichten in Tandem-Solarzellen oder Single-Heterojunction-Solarzellen, bzw. Metalloxid-Halbleitersensoren oder Multisensor-Arrays.

Diese Aufgabe wird durch das erfindungsgemäße Verfahren mit den kennzeichnenden Merkmalen des unabhängigen Anspruchs 1 gelöst. Die abhängigen Ansprüche zeigen weitere vorteilhafte Ausgestaltungen des erfindungsgemäßen Verfahrens. Die erfindungsgemäßen Verwendungen der Metalloxidschichten werden durch die Ansprüche 14 bis 16 beschrieben. Der Wortlaut sämtlicher Ansprüche wird hiermit durch Bezugnahme zum Inhalt der Beschreibung gemacht. Die Erfindung umfasst auch alle sinnvollen und insbesondere alle erwähnten Kombinationen von unabhängigen und/oder abhängigen Ansprüchen.

### Beschreibung

In den Zeichnungen und der schriftlichen Beschreibung sind die einzelnen Merkmale der Erfindung mit Bezugsziffern bezeichnet, wobei gleiche Bezugsziffern in den Zeichnungen und der schriftlichen Beschreibung durchwegs auf gleiche Merkmale verweisen.

Bei der vorliegenden Erfindung handelt es sich um ein Verfahren zur Herstellung von Metalloxidschichten durch Kathodenzerstäubung, umfassend die Verwendung von mindestens einem Inertgas, bevorzugt Argon, als Arbeitsgas und einem ersten, oxidierend wirkenden Reaktivgas, bevorzugt Sauerstoff (O₂), sowie mindestens einem weiteren Reaktivgas, wobei das mindestens eine weitere Reaktivgas in geeigneter Konzentration vor und/oder während des Sputterprozesses zugegeben wird.

Der Begriff "Arbeitsgas" umfasst im Sinne der hier offenbarten Erfindung alle für die Sputter- bzw. Kathodenzerstäubungs-Technologie bekanntermaßen verwendbaren Inertgase wie Helium, Neon, Argon, Krypton und Xenon, sowie Mischungen von mindestens zwei Inertgasen. Bevorzugt wird Argon eingesetzt.

Der Begriff "Reaktivgas" umfasst im Sinne der hier offenbarten Erfindung alle bei Umgebungstemperatur gasförmigen Substanzen sowie alle Flüssigkeiten oder Feststoffe, die unter den apparativen Bedingungen des erfindungsgemäßen Verfahrens, das heißt bei Temperaturen von -20°C bis 1000 °C und absoluten Drücken von 10 mbar bis 10⁻⁸ mbar in den gasförmigen Zustand überführt werden können. Bevorzugt ist ein Gesamtdruck (Arbeitsdruck während des Zerstäubungsprozesses) in der Vakuumkammer im Bereich von 1 mbar bis 10⁻⁶ mbar, bevorzugter ist ein Gesamtdruck im Bereich von 0,1 mbar bis 10⁻⁵ mbar, weiter bevorzugt ist ein Gesamtdruck im Bereich von 10⁻² mbar bis 10⁻³ mbar, und ganz besonders bevorzugt ist ein Gesamtdruck von 6·10⁻³ mbar bis 8·10⁻³ mbar. Es ist jedoch auch möglich, den Gesamtdruck oder einzelne Partialdrücke während des erfindungsgemäßen Verfahrens zu variieren, ohne den Umfang der Erfindung oder ihrer Äquivalente zu verlassen.

Ein Vorteil des erfindungsgemäßen Verfahrens ist, daß es sich in einem sehr weiten Temperaturbereich von -20°C bis +1000 °C anwenden läßt. Bevorzugt ist die Durchführung im Bereich von 500 °C bis -10 °C, weiter bevorzugt ist die Durchführung im Bereich von 200 °C bis 0 °C, und ganz besonders bevorzugt ist die Durchführung ohne Substratheizung, also in einem Temperaturbereich von ca. 50°C bis 10°C.

Bei dem ersten Reaktivgas handelt es sich bevorzugt um Sauerstoff (O₂). Es können aber auch andere gegenüber dem jeweiligen Metall oxidierend wirkende Substanzen wie zum Beispiel Stickstoffdioxid (NO₂) oder Wasserstoffperoxid (H₂O₂) verwendet werden.

Überraschenderweise wurde gefunden, dass sich die elektrischen Eigenschaften von zum Beispiel Kupferoxid, ausgedrückt durch die Transportgrößen spezifischer Widerstand, Ladungsträgerkonzentration und Ladungsträgermobilität sehr stark verbessern, wenn die im Stand der Technik als separater Prozessschritt bekannte Wasserstoffbehandlung bereits während des Schichtbildungsprozesses in geeigneter Weise durchgeführt wird. In den beigefügten Zeichnungen sind die Verläufe dieser charakteristischen Parameter, jeweils in Abhängigkeit vom Wasserstofffluß am Beispiel einer Cu₂O-Schicht graphisch dargestellt. Fig. 1 zeigt hierbei beispielhaft den Verlauf des spezifischen Widerstandes, Fig. 2 denjenigen der Hall-Ladungsträgerkonzentration, und Fig. 3 den der Hall-Ladungsträgerbeweglichkeit.

Ohne an eine Theorie gebunden zu sein, kann die Wirkungsweise des erfindungsgemäßen Verfahrens wie folgt beschrieben werden: Die Passivierung der Defekte an den Korngrenzen, die in der Literatur üblicherweise als Absättigung der sog. "dangling-bonds" beschrieben wird, erfolgt durch das erfindungsgemäße Verfahren bereits während, und nicht erst nach der Metalloxid-Schichtdeposition via Kathodenzerstäubung. Eine Nachbehandlung gemäß dem Stand der Technik kann nur diejenigen Defekte ausheilen/passivieren, die nach Abschluss des Schichtaufbaus noch oberflächlich zugänglich sind, bzw. die während der Dauer der Nachbehandlung per Diffusion erreichbar sind. Durch das erfindungsgemäße Verfahren werden zusätzlich Defekte ausgeheilt/passiviert, die im weiteren Verlauf des Schichtaufbaus eingeschlossen werden, und daher keiner Nachbehandlung mehr zugänglich sind, bzw. deren Ausheilung eine sehr viel längere Behandlungsdauer benötigen würde.

Hinsichtlich der Auswahl geeigneter Substrate zur Abscheidung der erfindungsgemäßen Schichten bestehen keine Einschränkungen. Jedes beliebige Substrat, das unter den während des Sputterprozesses herrschenden Bedingungen stabil ist, und auf dem sich eine erfindungsgemäße Schicht durch Kathodenzerstäubung bzw. Sputtern abscheiden lässt, kann im Rahmen der Erfindung verwendet werden. Insbesondere bevorzugt sind Substrate aus Glas, Rubin, Saphir, Keramik, Metall und Polymeren (z.B. Polycarbonat, Polymethylmethacrylat usw.). Die Substrate können starr oder flexibel, elektrisch leitend oder isolierend sein.

Der Auswahl der für die Anwendung der Erfindung gewählten Sputter- bzw. Kathodenzerstäubungsanlage sind keine Grenzen gesetzt. Insbesondere kann das erfindungsgemäße Verfahren sowohl in Magnetron-Sputteranlagen angewendet werden als auch in Anlagen ohne Magnetron-Unterstützung. Für den Fachmann ist ohne weiteres ersichtlich, dass das erfindungsgemäße Verfahren sowohl in DC-Sputteranlagen, das heißt unter Anwendung eines Gleichspannungsfeldes, durchgeführt werden kann, als auch unter Anwendung eines hochfrequenten Wechselspannungsfeldes (sog. HF-Sputteranlagen). Es ist weiterhin ohne weiteres ersichtlich, dass natürlich auch die Kombination beider Verfahren, also die Anwendung eines Wechselspannungsfeldes in einem überlagerten Gleichspannungsfeld in den Umfang der Erfindung fällt.

Form und Größe der Vakuumkammer 1, in der das erfindungsgemäße Verfahren durchgeführt wird, sowie Anzahl und Anordnung der Targets und Substrate darin, sind ebenfalls in beliebigem Maße variierbar, ohne dadurch den Umfang der Erfindung zu verlassen.

Erfindungsgemäß als Targetmaterial verwendbare Metalle sind alle Metalle, die sich mittels reaktiver Kathodenzerstäubung als Metalloxidschicht auf beliebigen Substraten abscheiden lassen.

Beispiele für erfindungsgemäß einsetzbare Metalle sind Kupfer (Cu), Zinn (Sn), Zink (Zn), Wolfram (W), Titan (Ti), Molybdän (Mo) oder Zirkonium (Zr), wobei diese Aufzählung die erfindungsgemäß einsetzbaren Metalle nicht auf die genannten Beispiele einschränkt, sondern auch alle sonstigen Metalle, die sich mittels Sputterdeposition als Metalloxid abscheiden lassen, erfindungsgemäß eingesetzt werden können. Besonders bevorzugt ist der Einsatz von Kupfer (Cu) als Targetmaterial, wobei von den bekannten Kupferoxiden Kupfer(I)-oxid (Cu₂O), Kupfer(II)-oxid (CuO) und dem gemischtvalenten Oxid Cu₄O₃ das gemischtvalente Oxid Cu₄O₃ bevorzugt ist gegenüber dem CuO, und das Cu₂O besonders bevorzugt ist gegenüber dem Cu₄O₃.

Natürlich können die vorstehend explizit oder implizit genannten erfindungsgemäß einsetzbaren Metalle auch beliebig miteinander kombiniert werden, so daß die Abscheidung von Mischoxidschichten aus mindestens zwei oder mehr Metalloxiden ebenfalls in den Umfang der Erfindung fällt.

Als Targets für die Durchführung des Sputterprozesses können sowohl metallische als auch keramische Targets verwendet werden, wobei die Partialdrücke der Reaktivgase geeignet an das jeweils verwendete Target angepaßt werden müssen. Neben Targets, die nur Atome bzw. Ionen eines Metalls enthalten, können auch Targets verwendet werden, die Atome bzw. Ionen mehrerer Metalle enthalten. Bevorzugt enthalten Targets, die mehrere Metalle enthalten, diese in dem stöchiometrischen Verhältnis, in dem die Metalle letztendlich in der angestrebten Metalloxidschicht eingebaut werden. Bei Metallen, die unterschiedliche Flüchtigkeiten aufweisen, kann das Verhältnis der Metalle in dem Target in besonders vorteilhafter Weise von dem stöchiometrischen Verhältnis der Metalle in der Oxidschicht abweichen, so dass infolge der unterschiedlichen Flüchtigkeit in der Gasphase das für die Oxidbildung günstigste stöchiometrische Verhältnis der Metalle in der Gasphase bzw. in der sich bildenden Oxidschicht zueinander vorliegt. Das verwendete Target kann neben dem mindestens einen Basismaterial auch Dotierstoffe enthalten. Als Dotierstoffe können ein oder mehrere Metalle aus der Liste enthaltend die Metalle Au, Ag, Fe, Co, Ni, Ru, Rh, Pd, Os, Ir und Pt ausgewählt werden, wobei diese Aufzählung die erfindungsgemäß einsetzbaren Dotierstoffe nicht auf die genannten Beispiele einschränkt.

Bei der Durchführung des erfindungsgemäßen Verfahrens ist das Mischungsverhältnis der beiden Reaktivgase von entscheidender Bedeutung. Bevorzugt ist, dass das Verhältnis der Flußraten des mindestens einen weiteren Reaktivgases relativ zu dem ersten Reaktivgas im Bereich von 1 zu 340 bis 1 zu 1,7, weiter bevorzugt im Bereich von 1 zu 68 bis 1 zu 3,4, und besonders bevorzugt im Bereich von 1 zu 34 bis 1 zu 6,8 liegt. Ohne Berücksichtigung des Arbeitsgases, dessen Flußrate naturgemäß in weiten Bereichen variieren kann, um den Gesamtdruck in der Vakuumkammer 1 einzustellen, führen diese Verhältnisse der Flußraten zu den folgenden erfindungsgemäßen Konzentrationsbereichen des zweiten Reaktivgases, bezogen auf das erste Reaktivgas: 0,3% bis 37%, bevorzugt 1,4% bis 23%, besonders bevorzugt 2,9% bis 13%.

Es ist offensichtlich, dass die Flußrate des Arbeitsgases in beliebigem Umfange variiert werden kann, ohne den Umfang der Erfindung zu verlassen. Durch die Variation des Arbeitsgasdruckes wird im Wesentlichen die Abscheidungsgeschwindigkeit beeinflusst.

Die Angabe der Flußraten erfolgt in der Einheit "sccm/Min.", das heißt "Standard-Kubikzentimeter pro Minute". In den Zeichnungen wird in verkürzter Form synonym auch die Bezeichnung "sccm" verwendet. Dem Fachmann ist bekannt, daß es sich bei der Angabe "Standardkubikzentimeter" um eine Volumenangabe von gasförmigen Stoffen unter Standardbedingungen handelt, also bei einem Druck von 101325 Pa und einer Temperatur von 273,15 K.

Weiterhin ist für den Fachmann offensichtlich, daß die Dicke der abgeschiedenen Metalloxidschicht ebenfalls kein beschränkender Parameter der erfindungsgemäßen Metalloxidschichten ist. Sie kann in weiten Bereichen von 1 nm bis zu 1 mm variieren, je nach gewünschter Transparenz, Leitfähigkeit oder mechanischen Stabilität. Bevorzugt sind Schichtdicken von 10 nm bis 100 µm, besonders bevorzugt sind Schichtdicken im Bereich von 100 nm bis 10 µm.

Das zweite Reaktivgas wird erfindungsgemäß zeitgleich mit dem ersten Reaktivgas zugeleitet. Es kann aber auch zeitversetzt zugeführt werden, oder aber pulsweise mit variablen Pulslängen. Auch das erste Reaktivgas kann zeitversetzt bzw. pulsweise mit variablen Pulslängen zugeführt werden. Es ist ebenfalls möglich, alle verwendeten Reaktivgase pulsweise zuzuführen, insbesondere derart, dass sie abwechselnd oder zeitgleich zugeführt werden. Dabei kann für jedes Reaktivgas eine eigene Zuleitung verwendet werden; es können aber auch mehrere Reaktivgase durch eine gemeinsame Zuleitung zugeführt werden.

Eine wesentliche für die Erfindung relevante Eigenschaft des zusätzlichen Reaktivgases ist, dass es sich um ein Gas handelt, das gegenüber dem ersten Reaktivgas reduzierende Eigenschaften aufweist. Beispiele für erfindungsgemäß einsetzbare weitere Reaktivgase sind Wasserstoff (H₂), Kohlenmonoxid (CO), Stickstoffmonoxid (NO), Ammoniak (NH₃), Wasserdampf (H₂O), Schwefelwasserstoff (H₂S), Methan (CH₄), Ethan (C₂H₆), Propan (C₃H₈) und Butan (C₄H₁₀), wobei diese Aufzählung die erfindungsgemäß einsetzbaren Reaktivgase nicht auf die genannten Beispiele einschränkt, sondern alle sonstigen ebenfalls gegenüber dem ersten Reaktivgas, insbesondere Sauerstoff, reduzierend wirkenden Gase oder Dämpfe erfindungsgemäß eingesetzt werden können. Besonders bevorzugt ist der Einsatz von Wasserstoffgas als mindestens zweites weiteres Reaktivgas.

Durch geeignete Wahl der Verfahrensparameter, insbesondere den Sauerstoff-Partialdruck kann zum Beispiel bei Verwendung von Kupfer gesteuert werden, welches von den bekannten Kupferoxiden Kupfer(I)-oxid (Cu₂O), Kupfer(II)-oxid (CuO) oder das gemischtvalente Oxid Cu₄O₃ die Schicht ausbildet, wobei das gemischtvalente Oxid Cu₄O₃ bevorzugt ist gegenüber dem CuO, und das Cu₂O besonders bevorzugt ist gegenüber dem Cu₄O₃. In einer weiteren vorteilhaften Ausgestaltung kann zum Beispiel eine Kupferoxidschicht auch als eine amorphe, kristalline oder teilkristalline Schicht ausgebildet sein, umfassend mindestens zwei der drei Kupferoxide Cu₂O, CuO und Cu₄O₃. Dies kann erreicht werden, indem der Sauerstoff-Partialdruck während des Sputterprozesses variiert wird.

Bei der verwendeten Sputterleistung handelt es sich ebenfalls um einen Verfahrensparameter, der in weiten Grenzen variiert werden kann, ohne den Umfang der

Erfindung zu verlassen. Sie ist sehr stark abhängig von der Größe und Geometrie der Vakuumkammer **1,** sowie des Targets **4** und der Entfernung des Substrates **5** vom Target **4,** und daher von Gerät zu Gerät verschieden. Eine näherungsweise Normierung erfolgt durch Angabe als targetflächenbezogene Leistungsdichte. Erfindungsgemäß liegt sie im Bereich von 0,5 W/cm² bis 20 W/cm², bevorzugt im Bereich von 2 W/cm² bis 10 W/cm², und besonders bevorzugt im Bereich von 3 W/cm² bis 4 W/cm².

Infolge der zahlreichen vorgenannten Parameter, die die Eigenschaften der Metalloxidschichten beeinflussen, und die variiert werden können ohne den Umfang der Erfindung oder ihrer Äquivalent zu verlassen, ist ohne weiteres ersichtlich, daß es ebenfalls in den Umfang der Erfindung fällt, das Verfahren geregelt durchzuführen, indem beispielsweise mindestens ein charakteristischer Parameter der entstehenden Metalloxidschicht während des Prozesses gemessen wird, und einer oder mehrere Prozessparameter in Abhängigkeit vom jeweils aktuellen mindestens einen Meßwert geändert werden, um eine Schicht mit den gewünschten Eigenschaften zu erhalten. Geeignete Schichtparameter sind zum Beispiel, aber nicht ausschließlich: Schichtdicke, Transparenz, Farbe oder elektrische Leitfähigkeit.

Die erfindungsgemäßen Metalloxidschichten können erfindungsgemäß in vielfältiger Art und Weise angewendet werden.

Bevorzugt ist z.B. die Verwendung der Metalloxidschichten zur Erzielung von optischen Effekten auf transparenten Substraten. Besonders bevorzugt ist die Verwendung der Metalloxidschichten als sensitive Schicht in Metalloxid-Halbleitersensoren oder in Multisensor-Arrays, und ganz besonders bevorzugt ist insbesondere die Verwendung der Kupferoxidschichten unter Ausnutzung ihrer elektrischen/elektronischen Halbleiter-Eigenschaften zum Bau von Single-Heterojunction-Solarzellen oder zum Bau von Tandem-Solarzellen. In Tandem-Solarzellen können die erfindungsgemäßen Kupferoxidschichten vorteilhaft als Frontzellen eingesetzt werden.

Weitere Ziele, Merkmale, Vorteile und Anwendungsmöglichkeiten der Erfindung ergeben sich aus der nachfolgenden Beschreibung von Ausführungsbeispielen, und den Zeichnungen. Sämtliche aus den Ansprüchen, der Beschreibung und den Zeichnungen hervorgehenden Merkmale und Vorteile, einschließlich konstruktiver Einzelheiten, räumlicher Anordnungen und Verfahrensschritten, können sowohl für sich, als auch in den verschiedensten Kombinationen erfindungswesentlich sein, unabhängig von ihrer Zusammenfassung in den Ansprüchen oder deren Rückbeziehung.

### Bezugszeichenliste

1 - Vakuumkammer
2 - Auslass
3 - Vakuumpumpe
4 - Target
5 - Substrat
6 - Hochfrequenzgenerator
7 - Zuleitung Argon
8 - Zuleitung Sauerstoff
9 - Zuleitung Wasserstoff
10 - Sammelzuleitung der Gasmischung
11 - Ausströmöffnungen

### Kurze Beschreibung der Zeichnungen

Die Zeichnungen zeigen im Einzelnen:

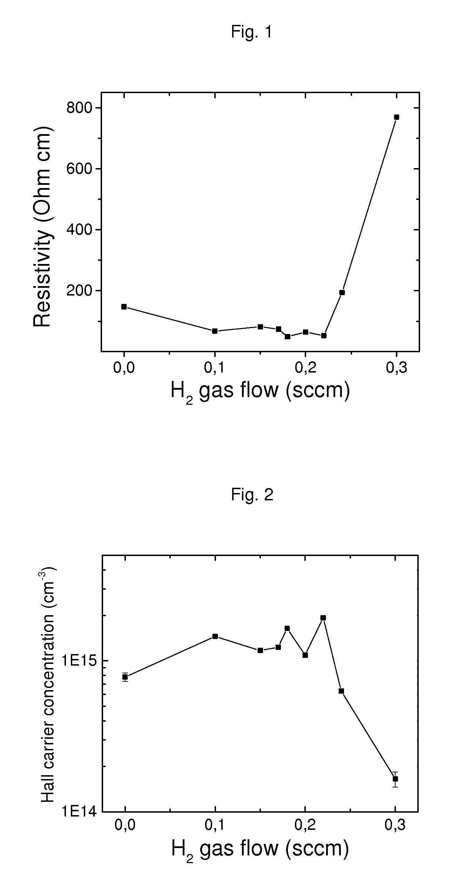

- - Fig. 1:: Spezifischer Widerstand von Cu₂O-Schichten, abgeschieden bei 920 K, als Funktion des Wasserstoffflusses bei festem Ar/O₂-Verhältnis von 47 sccm/Min. zu 3,4 sccm/Min.
- - Fig. 2:: Hall-Ladungsträgerkonzentration von Cu₂O-Schichten, abgeschieden bei 920 K, als Funktion des Wasserstoffflusses bei festem Ar/O₂-Verhältnis von 47 sccm/Min. zu 3,4 sccm/Min.

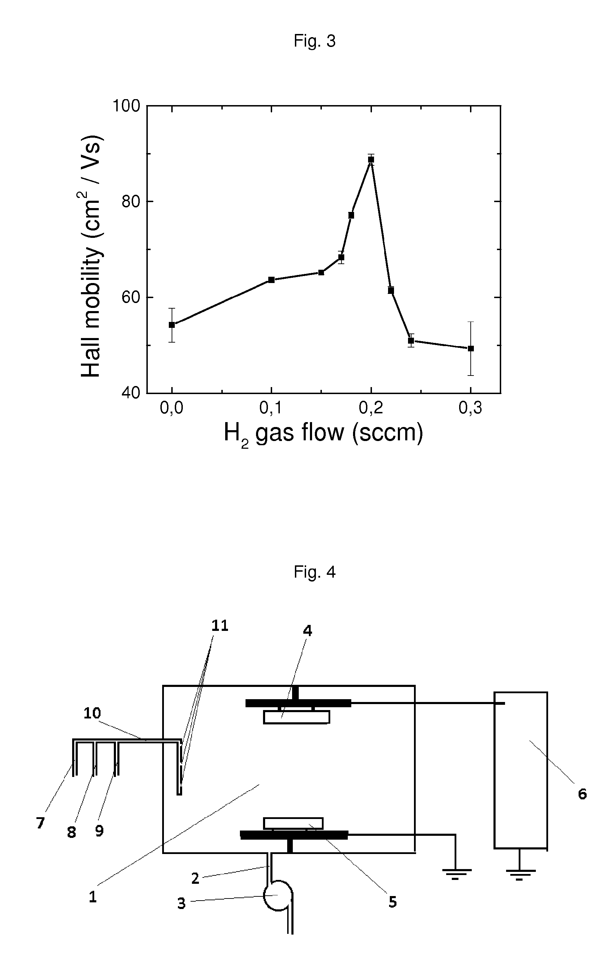

- - Fig. 3:: Hall-Beweglichkeit von Cu₂O-Schichten, abgeschieden bei 920 K, als Funktion des Wasserstoffflusses bei festem Ar/O₂-Verhältnis von 47 sccm/Min. zu 3,4 sccm/Min.
- - Fig. 4:: Schematische Darstellung einer für die Durchführung des erfindungsgemäßen Verfahrens geeigneten Sputteranlage.

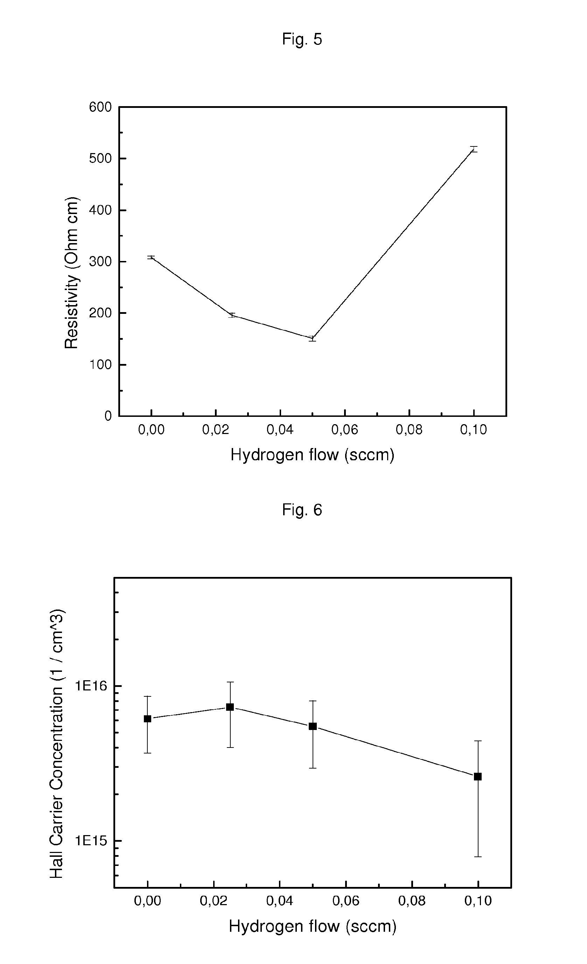

- - Fig. 5:: Spezifischer Widerstand von Cu₂O-Schichten, abgeschieden bei Umgebungstemperatur (ca. 10 °C bis30 °C), als Funktion des Wasserstoffflusses bei festem Ar/O₂-Verhältnis von 47 sccm/Min. zu 2,85 sccm/Min.
- - Fig. 6:: Hall-Ladungsträgerkonzentration von Cu₂O-Schichten, abgeschieden bei Umgebungstemperatur (ca. 10 °C bis 30 °C), als Funktion des Wasserstoffflusses bei festem Ar/O₂-Verhältnis von 47 sccm/Min. zu 2,85 sccm/Min.

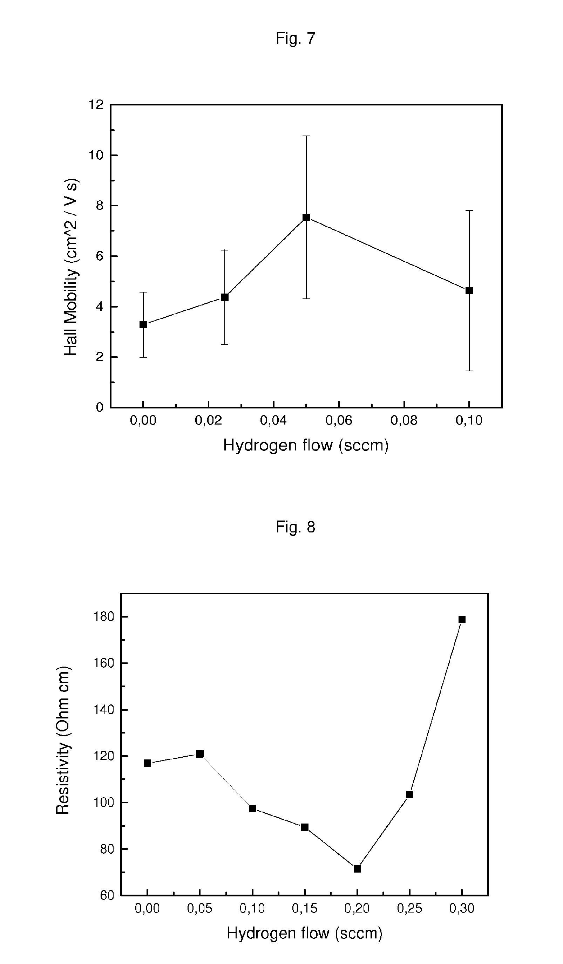

- - Fig. 7:: Hall-Beweglichkeit von Cu₂O-Schichten, abgeschieden bei Umgebungstemperatur (ca. 10 °C bis30 °C), als Funktion des Wasserstoffflusses bei festem Ar/O₂-Verhältnis von 47 sccm/Min. zu 2,85 sccm/Min.
- - Fig. 8:: Spezifischer Widerstand von Cu₂O-Schichten, abgeschieden bei 620 K, als Funktion des Wasserstoffflusses bei festem Ar/O₂-Verhältnis von 47 sccm/Min. zu 3,25 sccm/Min.

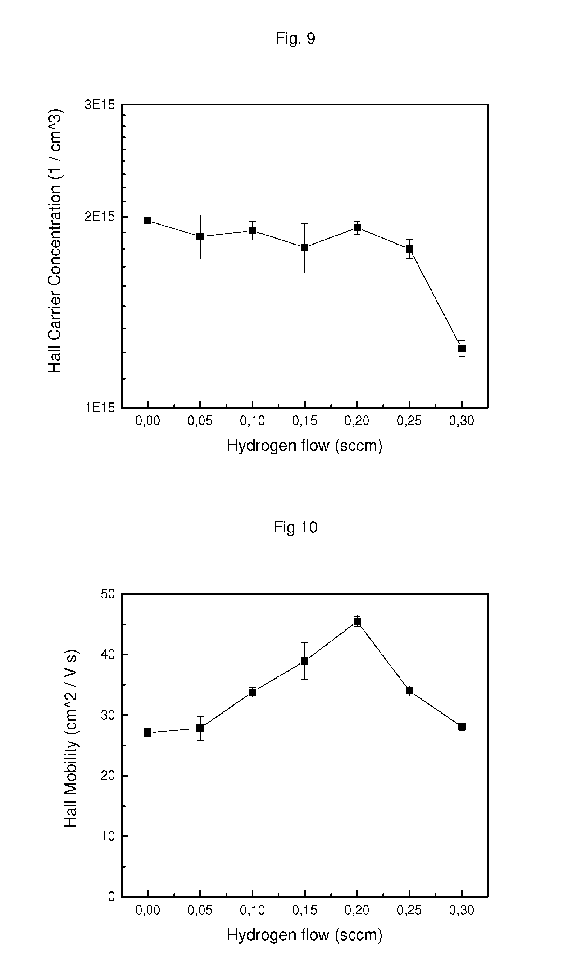

- - Fig. 9:: Hall-Ladungsträgerkonzentration von Cu₂O-Schichten, abgeschieden bei 620 K, als Funktion des Wasserstoffflusses bei festem Ar/O₂-Verhältnis von 47 sccm/Min. zu 3,25 sccm/Min.
- - Fig. 10:: Hall-Beweglichkeit von Cu₂O-Schichten, abgeschieden bei 620 K, als Funktion des Wasserstoffflusses bei festem Ar/O₂-Verhältnis von 47 sccm/Min. zu 3,25 sccm/Min.

### Ausführungsbeispiele

Die Erfindung wird nachfolgend anhand von Ausführungsbeispielen unter Bezugnahme auf die anhängenden Zeichnungen näher beschrieben, ohne dass damit eine Beschränkung der Erfindung auf diese Beispiele verbunden ist.

Für die Ausführungsbeispiele wurde die in Fig. 4 schematisch dargestellte Sputteranlage verwendet. Sie besteht aus einer Vakuumkammer **1,** die über den Auslass **2** mittels Vakuumpumpe **3** evakuiert werden kann, und in der das Target **4** und das zu beschichtende Substrat **5** angeordnet sind. Das Target **4** wird mit einem Hochfrequenzgenerator **6** verbunden, und das Substrat **5** wird geerdet, so dass das entstehende HF-Plasma Target-Atome aus dem Target herauslöst und ionisiert. Die ionisierten Atome werden infolge der elektrostatischen Anziehung auf das Substrat hin beschleunigt. Über die Zuleitungen **7, 8** und **9** werden das Arbeitsgas sowie die Reaktivgase in die gemeinsame Zuleitung **10** eingespeist und somit vorgemischt in die Vakuumkammer **1** eingeleitet. Die Flußraten werden so eingestellt, dass sich die gewünschten Konzentrationsverhältnisse der Gase zueinander sowie der angestrebte Gesamtdruck während des Betriebs einstellen. Zur gleichmäßigen Verteilung der Gasmischung weist die Sammelzuleitung **10** innerhalb der Vakuumkammer **1** mehrere Ausströmungsöffnungen **11** auf. Es ist auch möglich, für jedes einzelne Prozeßgas (Arbeitsgas und Reaktivgase) eine eigene Zuleitung **10** in die Vakuumkammer **1** vorzusehen. Als Hochfrequenzgenerator **6** können sowohl beliebige handelsübliche Geräte als auch selbst gebaute Vorrichtungen verwendet werden, sofern sie Strahlung ausreichender Leistung und geeigneter Frequenz erzeugen. Bevorzugt wird eine Sputterfrequenz von 13,54 MHz verwendet, da es sich hierbei um eine freie Frequenz handelt, die keinen behördlichen Verwendungs-Vorgaben unterliegt. Andere Frequenzen können jedoch prinzipiell ebenfalls verwendet werden, ohne den Umfang der Erfindung zu verlassen.

Die Messung der elektrischen Eigenschaften der erhaltenen Metalloxidschichten erfolgt in Anlehnung an die Norm ASTM F 76. Der Meßaufbau besteht aus folgenden Komponenten:
- Präzisionsstromquelle (Keithley Instruments Inc. / Tektronix)
- Nanovoltmeter (Keithley Instruments Inc. / Tektronix)
- Picoamperemeter (Keithley Instruments Inc. / Tektronix)
- Scanner & Hall-Effekt-Karte (Keithley Instruments Inc. / Tektronix)
- 1 T Elektromagnet von AEG mit Oxford Instruments Kaltfinger Flusskryostat, PID-Regler ITC503 und PtRh-Temperatursensor.

Die Messungen werden bis maximal 8V DC-Spannung ausgeführt, bevorzugt jedoch bei geringeren Spannungen, um thermische Drift in den Messgrößen infolge Aufheizung zu vermeiden. Für jede Messspannung werden 100 bis 1000 vorgemittelte Werte aufgenommen. Um die Messgenauigkeit zu verbessern, werden mittels Photolithographie hochsymmetrische Schichtgeometrien erzeugt, sogenannte "Kleeblatt-Geometrie", bzw. Van-der-Pauw-Geometrie.

### Beispiel 1:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3-Zoll-Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 3,4 sccm/Min. zugeführt. Als zweites Reaktivgas wird gleichzeitig Wasserstoff mit einer Flussrate von 0,2 sccm/Min. zugeführt. Die Substratheizungstemperatur wird auf 920 K eingestellt.

Mit diesen Parametern wird eine Cu₂O-Schicht von ca. 0,8 bis 1,1 µm Dicke erhalten, die folgende charakterisierenden elektronischen Parameter aufweist: Widerstand: ca. 80 Ohm·cm (vgl. Fig. 1)
Ladungsträgerkonzentration: ca. 1·10¹⁵ cm⁻³ (vgl. Fig. 2)
Ladungsträger-Beweglichkeit: ca. 88 cm² / Vs (vgl. Fig. 3)

### Beispiel 2:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 3,4 sccm/Min. zugeführt. Als zweites Reaktivgas wird gleichzeitig Wasserstoff mit einer Flussrate von 0,1 sccm/Min. zugeführt. Die Substratheizungstemperatur wird auf 920 K eingestellt.

Mit diesen Parametern wird eine Cu₂O-Schicht von ca. 0,8 bis 1,1 µm Dicke erhalten, die folgende charakterisierenden elektronischen Parameter aufweist: Widerstand: ca. 80 Ohm·cm (vgl. Fig. 1)
Ladungsträgerkonzentration: ca. 1·10¹⁵ cm⁻³ (vgl. Fig. 2)
Ladungsträger-Beweglichkeit: ca. 63 cm² / Vs (vgl. Fig. 3)

### Beispiel 3:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 3,4 sccm/Min. zugeführt. Als zweites Reaktivgas wird gleichzeitig Wasserstoff mit einer Flussrate von 0,3 sccm/Min. zugeführt. Die Substratheizungstemperatur wird auf 920 K eingestellt.

Mit diesen Parametern wird eine Cu₂O-Schicht von ca. 0,8 bis 1,1 µm Dicke erhalten, die folgende charakterisierenden elektronischen Parameter aufweist: Widerstand: ca. 800 Ohm·cm (vgl. Fig. 1)
Ladungsträgerkonzentration: ca. 1·10¹⁴ cm⁻³ (vgl. Fig. 2)
Ladungsträger-Beweglichkeit: ca. 50 cm² / Vs (vgl. Fig. 3)

### Beispiel 4:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 2,85 sccm/Min. zugeführt. Als zweites Reaktivgas wird gleichzeitig Wasserstoff mit einer Flussrate von 0,5 sccm/Min. zugeführt. Das Substrat wird nicht beheizt, so daß die Abscheidung bei Raumtemperatur (ca. 10 °C bis 30 °C) erfolgt.

Mit diesen Parametern wird eine Cu₂O-Schicht von ca. 0,6 bis 0,8 µm Dicke erhalten, die folgende charakterisierenden elektronischen Parameter aufweist: Widerstand: ca. 150 Ohm·cm (vgl. Fig. 5)
Ladungsträgerkonzentration: ca. 5,5·10¹⁵ cm⁻³ (vgl. Fig. 6)
Ladungsträger-Beweglichkeit: ca. 7,5 cm² / Vs (vgl. Fig. 7)

### Beispiel 5:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 3,25 sccm/Min. zugeführt. Als zweites Reaktivgas wird gleichzeitig Wasserstoff mit einer Flussrate von 0,2 sccm/Min. zugeführt. Die Substratheizungstemperatur wird auf 620 K eingestellt.

Mit diesen Parametern wird eine Cu₂O-Schicht von ca. 0,6 bis 0,8 µm Dicke erhalten, die folgende charakterisierenden elektronischen Parameter aufweist: Widerstand: ca. 70 Ohm·cm (vgl. Fig. 8)
Ladungsträgerkonzentration: ca. 1,9·10¹⁵ cm⁻³ (vgl. Fig. 9)
Ladungsträger-Beweglichkeit: ca. 45 cm² / Vs (vgl. Fig. 10)

### Beispiel 6:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 4,3 sccm/Min. zugeführt. Als zweites Reaktivgas wird gleichzeitig Wasserstoff mit einer Flussrate von 0,25 sccm/Min. zugeführt. Die Substratheizungstemperatur wird auf 620 K eingestellt.

Mit diesen Parametern wird eine Cu₄O₃-Schicht von ca. 0,6 bis 0,8 µm Dicke erhalten, die folgende charakterisierenden elektronischen Parameter aufweist:
Widerstand: 725 Ohm·cm
Ladungsträgerkonzentration: ca. 1,2·10¹⁵ cm⁻³
Ladungsträger-Beweglichkeit: ca. 7,2 cm² / Vs

### Beispiel 7:

Die Sputterfrequenz beträgt 13,54 MHz; die in das Plasma eingekoppelte Leistung beträgt (targetbezogene Flächenleistungsdichte) 3,44 W/cm². Als Target wird ein metallisches 3" Kupfertarget verwendet. Als Substrat dient ein beidseitig poliertes, c-Achsen-orientiertes Saphirsubstrat, das in einem Abstand von 10 cm zum Kupfertarget positioniert ist. Als Arbeitsgas dient Argon, das mit einer Flußrate von 47 sccm/Min. eingeleitet wird. Als erstes Reaktivgas wird gleichzeitig Sauerstoff mit einer Flußrate von 7,5 sccm/Min. zugeführt. Als zweites Reaktivgas wird gleichzeitig Wasserstoff mit einer Flussrate von 0,25 sccm/Min. zugeführt. Die Substratheizungstemperatur wird auf 620 K eingestellt.

Mit diesen Parametern wird eine CuO-Schicht von ca. 0,6 bis 0,8 µm Dicke erhalten, die folgende charakterisierenden elektronischen Parameter aufweist: Widerstand: 2100 Ohm·cm
Ladungsträgerkonzentration: ca. 2,3·10¹⁶ cm⁻³
Ladungsträger-Beweglichkeit: ca. 0,13 cm² / Vs

Es ist leicht ersichtlich, dass abhängig von den besonderen Umständen und der jeweiligen Anwendung viele Veränderungen und Modifikationen an dem beschriebenen Verfahren und der Vorrichtung vorgenommen werden können, ohne den durch die nachfolgenden Ansprüche definierten Bereich der Erfindung zu verlassen.

### Vorteile der Erfindung

Aus der vorstehenden Beschreibung der Erfindung ergeben sich somit die folgenden gewerblich anwendbaren Vorteile der Erfindung.

Durch Anwendung des erfindungsgemäßen Verfahrens entfällt die im Stand der Technik notwendige Nachbehandlung der Metalloxidschichten (insbesondere von

Kupferoxidschichten), was zu einer großen Zeitersparnis bei der Herstellung der Schichten führt.

Ein weiterer Vorteil des erfindungsgemäßen Verfahrens ist es, dass keine zusätzliche Apparatur benötigt wird, um eine separate Nachbehandlung in reduzierender Atmosphäre durchzuführen.

Das erfindungsgemäße Verfahren erlaubt darüber hinaus die Absenkung der Wachstumstemperatur während des Schichtbildungsprozesses, ohne wesentliche Einbußen bei der Schichtqualität hinnehmen zu müssen. Das führt zu einer vorteilhaften Energieersparnis im gesamten Herstellungsprozess.

Die Absenkung der Wachstumstemperatur hat zudem den sehr vorteilhaften Effekt, dass die Interdiffusion zwischen verschiedenen aufeinanderfolgend abgeschiedenen Schichten unterschiedlicher Materialkombinationen unterdrückt wird. Dadurch können dünnere Schichten hergestellt werden.

Gleichzeitig werden bei den niedrigen Temperaturen des erfindungsgemäßen Verfahrens Schichten mit elektronischen Eigenschaften erhalten, wie sie sonst nur bei Hochtemperaturschichten mit Nachbehandlung möglich sind. Die Vorteile des erfindungsgemäßen Verfahrens ergeben sich also ohne wesentliche Einbußen in den gewünschten elektronischen Eigenschaften.

## Patentansprüche

1. Verfahren zur Herstellung von Metalloxidschichten durch Kathodenzerstäubung, umfassend die Verwendung von mindestens einem Inertgas als Arbeitsgas und einem ersten, oxidierend wirkenden Reaktivgas, **dadurch gekennzeichnet, dass** mindestens ein weiteres Reaktivgas vor und/oder während des Sputterprozesses zugegeben wird.

2. Verfahren nach Anspruch 1, **dadurch gekennzeichnet, dass**
a. es sich bei dem mindestens einen Arbeitsgas um Argon (Ar) handelt,
und
b. es sich bei dem ersten, oxidierend wirkenden Reaktivgas um Sauerstoff (O*₂) handelt.

3. Verfahren nach Anspruch 1 oder 2, **dadurch gekennzeichnet, dass** das Verhältnis der Flußraten des mindestens einen weiteren Reaktivgases relativ zu dem ersten Reaktivgas im Bereich von 0,3% bis 37%, bevorzugt im Bereich von 1,4% bis 23%, und besonders bevorzugt im Bereich von 2,9% bis 13% liegt.

4. Verfahren nach einem der Ansprüche 1 bis 3, **dadurch gekennzeichnet dass** es sich bei dem mindestens einen weiteren Reaktivgas um ein Gas handelt, das gegenüber dem ersten Reaktivgas reduzierende Eigenschaften aufweist.

5. Verfahren nach einem der Ansprüche 1 bis 4, **dadurch gekennzeichnet dass** es sich bei dem mindestens einen weiteren Reaktivgas um Wasserstoffgas (H₂) handelt.

6. Verfahren nach einem der Ansprüche 1 bis 4, **dadurch gekennzeichnet dass** es sich bei dem mindestens einen weiteren Reaktivgas um ein Reaktivgas handelt, ausgewählt aus der folgenden Liste von Reaktivgasen, umfassend die Gase Kohlenmonoxid (CO), Stickstoffmonoxid (NO), Ammoniak (NH₃), Wasserdampf (H₂O), Schwefelwasserstoff (H₂S), Methan (CH₄), Ethan (C₂H₆), Propan (C₃H₈) und Butan (C₄H₁₀).

7. Verfahren nach einem der Ansprüche 1 bis 6, **dadurch gekennzeichnet dass** es sich bei der Metalloxidschicht um eine Metalloxidschicht eines der Metalle Kupfer (Cu), Zinn (Sn), Zink (Zn), Wolfram (W), Titan (Ti), Molybdän (Mo) oder Zirkonium (Zr) handelt.

8. Verfahren nach Anspruch 7, **dadurch gekennzeichnet dass** die Metalloxidschicht mindestens einen Dotierstoff umfasst, ausgewählt aus der Liste umfassend die Dotierstoffe Au, Ag, Fe, Co, Ni, Ru, Rh, Pd, Os, Ir und Pt.

9. Verfahren nach einem der Ansprüche 1 bis 8, **dadurch gekennzeichnet dass** die Metalloxidschicht Kupfer(I)-oxid, Cu₂O, umfasst.

10. Verfahren nach einem der Ansprüche 1 bis 8, **dadurch gekennzeichnet dass** die Metalloxidschicht Kupfer(II)-oxid, CuO, umfasst.

11. Verfahren nach einem der Ansprüche 1 bis 8, **dadurch gekennzeichnet dass** die Metalloxidschicht ein gemischtvalentes Kupferoxid, Cu₄O₃, umfasst.

12. Verfahren nach einem der Ansprüche 1 bis 8, **dadurch gekennzeichnet dass** die Metalloxidschicht mindestens zwei der drei Kupferoxide Cu₂O, CuO und Cu₄O₃ umfasst.

13. Metalloxidschicht, hergestellt nach einem der Ansprüche 1 bis 12.

14. Verwendung einer Metalloxidschicht gemäß einem der vorgenannten Ansprüche 1 bis 13 zur Herstellung einer Single-Heterojunction-Solarzelle.

15. Verwendung einer Metalloxidschicht gemäß einem der vorgenannten Ansprüche 1 bis 13 zur Herstellung einer Tandem-Solarzelle.

16. Verwendung einer Metalloxidschicht gemäß einem der vorgenannten Ansprüche 1 bis 13 als sensitive Schicht in einem Metalloxid-Halbleitersensor.
